(19) Europäisches Patentamt
European Patent Office
Office européen des brevets

(11) **EP 2 548 035 B1**

(12) **EUROPÄISCHE PATENTSCHRIFT**

(45) Veröffentlichungstag und Bekanntmachung des Hinweises auf die Patenterteilung:
**07.11.2018 Patentblatt 2018/45**

(21) Anmeldenummer: **11709389.8**

(22) Anmeldetag: **18.03.2011**

(51) Int Cl.:
***G01R 19/165*** (2006.01)

(86) Internationale Anmeldenummer:
**PCT/EP2011/054151**

(87) Internationale Veröffentlichungsnummer:
**WO 2011/113939 (22.09.2011 Gazette 2011/38)**

(54) **VERFAHREN ZUM MESSEN EINES ELEKTRISCHEN STROMS UND VORRICHTUNG HIERFÜR**

METHOD FOR MEASURING AN ELECTRICAL CURRENT AND APPARATUS THEREFOR

PROCÉDÉ DE MESURE D'UN COURANT ÉLECTRIQUE ET DISPOSITIF À CET EFFET

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **19.03.2010 DE 102010012101**
**18.03.2010 DE 102010011869**

(43) Veröffentlichungstag der Anmeldung:
**23.01.2013 Patentblatt 2013/04**

(73) Patentinhaber: **MAGNA STEYR Fahrzeugtechnik AG & Co KG**
**8041 Graz (AT)**

(72) Erfinder: **PILZ, Karl**
**A-8010 Graz (AT)**

(74) Vertreter: **Zangger, Bernd et al**
**Magna International Europe GmbH**
**Patentabteilung**
**Liebenauer Hauptstraße 317**
**8041 Graz (AT)**

(56) Entgegenhaltungen:
**EP-A2- 2 068 158          WO-A1-98/10301**
**WO-A1-2006/129275     GB-A- 2 322 488**
**US-A1- 2009 267 589**

**Beschreibung**

TECHNISCHES GEBIET

Die Erfindung betrifft ein Verfahren zum Messen eines elektrischen Stroms mit Hilfe eines in einen Strompfad eingefügten Feldeffekttransistors, bei dem ein Spannungsabfall zwischen Drain und Source am Transistor im Strompfad gemessen wird und der gesuchte Strom anhand des besagten Spannungsabfalls und eines bekannten Zusammenhangs zwischen Drain-Source-Strom und Drain-Source-Spannung ermittelt wird. Weiterhin betrifft die Erfindung eine Vorrichtung zum Messen eines elektrischen Stroms, umfassend einen Transistor zum Einfügen in einen Strompfad, Mittel zum Bestimmen eines Spannungsabfalls zwischen Drain und Source am Transistor im Strompfad und Mittel zum Bestimmen des gesuchten Stroms anhand des besagten Spannungsabfalls und eines bekannten Zusammenhangs zwischen Drain-Source-Strom und Drain-Source-Spannung.

STAND DER TECHNIK

Üblicherweise wird der elektrische Strom über den Spannungsabfall an einem ohmschen Messwiderstand (engl. "shunt") gemessen. Diese Messwiderstände bestehen aus einer speziellen Legierung und besitzen einen konstanten Widerstandswert. Der gemessene Spannungsabfall über den Shunt ist dann direkt proportional zum Stromfluss ($I=U/R$). Seit einiger Zeit werden für die Strommessung anstelle von ohmschen Widerständen auch Feldeffekttransistoren (FETs) eingesetzt. Dabei wird der Shunt durch den steuerbaren Kanalwiderstand $R_{ds}$ eines Feldeffekttransistors ersetzt.

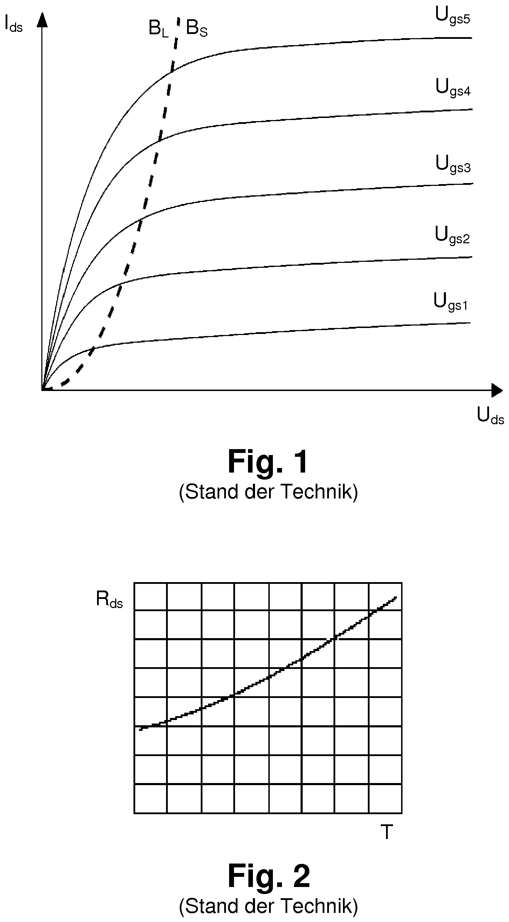

Der Kanalwiderstand eines MOSFETs $R_{ds}$ ist von der Temperatur des Transistors (genauer gesagt des Substrats des Transistors), von der Gate-Spannung $U_{gs}$ und von der Drain-Source Spannung $U_{ds}$ abhängig. Fig. 1 zeigt dazu ein Beispiel des an sich bekannten Zusammenhangs. In einem Diagramm, in dem der Drain-Source-Strom $I_{ds}$ über der Drain-Source-Spannung $U_{ds}$ aufgetragen ist, sind Kennlinien für verschiedene Gate-Source-Spannungen $U_{gs1}..U_{gs5}$ eingezeichnet. Der Kanalwiderstand $R_{ds}$ bestimmt sich bekanntlich durch $U_{ds}/I_{ds}$. Die strichlierte Linie in Fig. 1 trennt zusätzlich den linearen Bereich $B_L$ vom Sättigungsbereich $B_S$ des Transistors FET ab. Fig. 2 zeigt darüber hinaus die Abhängigkeit des Kanalwiderstands $R_{ds}$ von der Temperatur T. Aus dem Stand der Technik sind für die Strommessung mit Hilfe eines Feldeffekttransistors einige Lösungen bekannt.

Beispielsweise offenbart die WO 1998/010301 A1 dazu eine Strommessschaltung, bei einer Last über einen Transistor elektrische Energie zugeführt wird. Die am Transistor infolge des Stroms abfallende Spannung sowie die Temperatur des Transistors werden gemessen. Mit Hilfe der gemessenen Temperatur wird der aktuelle Kanalwiderstand bestimmt und mit Hilfe des Kanalwiderstands und des gemessenen Spannungsabfalls wird sodann der gesuchte Strom ermittelt.

Weiterhin zeigt die DE 10 2004 039 392 B3 ein Verfahren zur Erfassung des Stroms in einem elektrischen Gerät, das über einen mit dem Gerät gekoppelten Feldeffekttransistor nach dem Pulsweitenmodulationsverfahren angesteuert wird. Gemäß dem Verfahren werden die an der Source-Drain-Strecke des Feldeffekttransistors liegende Spannung sowie eine Temperatur in der Umgebung des Feldeffekttransistors gemessen. Aus den gemessenen Werten wird zusammen mit der Pulsweite und mit Hilfe einer Temperaturkompensation der aktuelle Strom ermittelt.

Die US 6,867,576 B2 offenbart darüber hinaus, dass ein Feldeffekttransistor kleiner Kapazität einem Leistungs-Feldeffekttransistor parallel geschalten werden kann, um aus dem Spannungsabfall am Leistungs-Feldeffekttransistor den Strom durch denselben zu bestimmen. Das Messergebnis wird dazu herangezogen, den Leistungs-Feldeffekttransistor abzuschalten, wenn die gemessene Spannung einen bestimmten Schwellwert überschreitet.

Die US 7,154,291 B2 offenbart schließlich ein Verfahren zum Messen eines Stroms durch einen Feldeffekttransistor, bei dem hierzu die Drain-Source-Spannung gemessen wird. Zusätzlich wird die Temperatur des Feldeffekttransistors gemessen, um den Kanalwiderstand desselben genau bestimmen zu können. Aus der genannten Spannung und dem Kanalwiderstand kann sodann leicht der gesuchte Strom durch den Transistor ermittelt werden.

US 2009/267589 A1 offenbart eine Schaltung zur Messung eines elektrischen Stroms, mit einem MOSFET mit einem Gate Anschluss, einem Darin Anschluss und einem Source Anschluss. Die Schaltung inkludiert eine Vorspannungsschaltung, zur Erzeugung einer Vorspannung am Gate Anschluss des MOSFET, so dass der MOSFET im linearen Bereich arbeitet.

EP 2 068158 A2 offenbart eine Vorrichtung zum Messen eines Laststroms in einem Lastkreis, mit einem aus zwei FET bestehenden Schalter, einem Stellmittel zum Konstanthalten der Ausgangsgröße des Schalters auf einem vorbestimmten Wert und einem Auswertemittel zum Ermitteln des Laststroms.

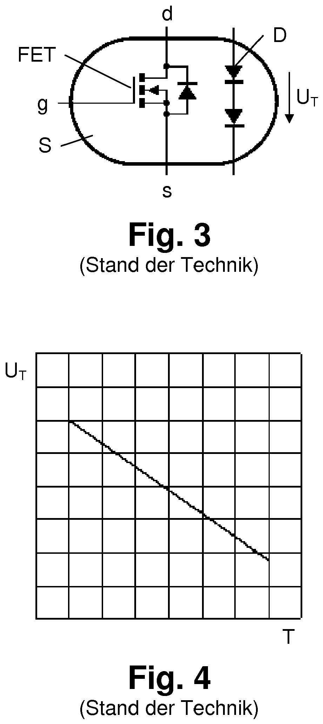

Die Fig. 3 zeigt weiterhin eine an sich bekannte Anordnung eines Feldeffekttransistors FET, welcher mit Temperaturmessdioden D auf einem gemeinsamen Substrat S angeordnet ist. Der Feldeffekttransistor FET umfasst Anschlüsse für Gate g, Drain d und Source s. Auf diese Weise entspricht die Temperatur der Temperaturmessdioden D im Wesentlichen der Transistortemperatur T, wodurch Messfehler weitgehend vermieden werden können. Fig. 4 zeigt darüber hinaus den Zusammenhang der an den Temperaturmessdioden D abfallenden Spannung $U_T$ und der Temperatur T.

Nachteilig an den bekannten Methoden ist nun, dass bloß Ströme in einem relativ kleinen Bereich gemessen werden können. Für große Messbereiche sind die bekannten Schaltungen daher ungeeignet oder müssen mit komplizierten Messbereichserweiterungs-Schaltungen ergänzt werden.

OFFENBARUNG DER ERFINDUNG

Aufgabe der Erfindung ist es daher, ein verbessertes Verfahren beziehungsweise eine verbesserte Vorrichtung zum Messen elektrischer Ströme anzugeben, insbesondere für relativ große Messbereiche.

Die Erfindung wird mit einem Verfahren nach Anspruch 1 zum Messen eines elektrischen Stroms mit Hilfe eines in einen Strompfad eingefügten Feldeffekttransistors gelöst, umfassend die Schritte:

- Anlegen einer Steuerspannung zwischen Gate und Source des Transistors derart, dass der Spannungsabfall zwischen Drain und Source am Transistor im Strompfad innerhalb eines vorgebbaren Bereichs bleibt,
- Bestimmen des besagten Spannungsabfalls,
- Bestimmen der Steuerspannung,
- Bestimmen des gesuchten Stroms anhand des besagten Spannungsabfalls, der Steuerspannung und eines bekannten Zusammenhangs zwischen Drain-Source-Strom, Drain-Source-Spannung und Gate-Source-Spannung, wobei die Steuerspannung zwischen Gate und Source des Transistors konstant gehalten wird, solange der Spannungsabfall zwischen Drain und Source im vorgebbaren Bereich liegt und die Steuerspannung um einen diskreten Wert erhöht bzw. verringert wird, wenn der Spannungsabfall zwischen Drain und Source den vorgebbaren Bereich verlässt.

Die Bestimmung der Steuerspannung ist dabei ein sehr einfacher Vorgang, der gewöhnlich beispielsweise keine Messung erfordert, da die Steuerspannung ja im beschriebenen Verfahren vorgegeben wird.

Weiterhin wird die Erfindung mit einer Vorrichtung nach Anspruch 7 zum Messen eines elektrischen Stroms gelöst, umfassend

- einen Transistor zum Einfügen in einen Strompfad,
- eine Regeleinrichtung, welche zum Anlegen einer Steuerspannung zwischen Gate und Source des Transistors vorgesehen ist, derart, dass der Spannungsabfall zwischen Drain und Source am Transistor im Strompfad innerhalb eines vorgebbaren Bereichs bleibt, wobei die Steuerspannung zwischen Gate und Source des Transistors konstant gehalten wird solange der Spannungsabfall zwischen Drain und Source im vorgebbaren Bereich liegt und die Steuerspannung um einen diskreten Wert erhöht bzw. verringert wird, wenn der Spannungsabfall zwischen Drain und Source den vorgebbaren Bereich verlässt,
- Mittel zum Bestimmen des besagten Spannungsabfalls und der Steuerspannung,
- Mittel zum Bestimmen des gesuchten Stroms anhand des besagten Spannungsabfalls, der Steuerspannung und eines bekannten Zusammenhangs zwischen Drain-Source-Strom, Drain-Source-Spannung und Gate-Source-Spannung.

Durch die Erfindung wird die im Stand der Technik vorhandene Einschränkung überwunden, dass der Feldeffekttransistor nur im Schalterbetrieb beziehungsweise im Sättigungsbereich betrieben werden darf, da bei bekannten Lösungen bloß die Abhängigkeit des Kanalwiderstands von der Temperatur berücksichtigt wird. Erfindungsgemäß wird der Kanalwiderstand $R_{ds}$ nun so geregelt, dass der Spannungsabfall $U_{ds}$ klein bleibt und somit das Messobjekt nicht beeinflusst Dadurch ist es möglich, sowohl große Ströme (bei kleinem $R_{ds}$) als auch sehr kleine Ströme (bei großem $R_{ds}$) zu messen. Die Transistortemperatur T ist im Wesentlichen durch die vom Stromfluss hervorgerufene Verlustleistung abhängig und kann daher wenig beeinflusst werden. Also erfolgt die Einstellung eines passenden Kanalwiderstands $R_{ds}$ über die Gate-Source-Spannung $U_{gs}$. Dazu wird die Gate-Spannung $U_{gs}$ so geregelt, dass die Drain-Source-Spannung $U_{ds}$ innerhalb definierter Grenzen (z.B. 10mV-90mV) liegt. Dadurch bleibt der Einfluss auf das Messobjekt klein und die Verlustleistung ist überschaubar. Die Geschwindigkeit der erfassbaren Stromänderungen hängt dabei lediglich durch Rechengeschwindigkeit der verwendeten Hardware und der Abtastgeschwindigkeit der ADCs (Analog Digital Converter) bzw. DACs (Digital Analog Converter) ab. Der hohe Dynamikbereich des beschriebenen Messprinzips wird also unter anderem dadurch erreicht, dass der Feldeffekttransistor einerseits nicht als Schalter (variable Gate-Spannung $U_{gs}$) und andererseits nicht nur im Linearbereich verwendet wird.

Der Spannungsabfall $U_{ds}$ zwischen Drain und Source wird bei Verlassen des vorgebbaren Bereichs wieder deutlich in diesen Bereich versetzt. Für die Bestimmung des gesuchten Stromes wird dadurch eine ganze Schar von Kennlinien (Zusammenhänge zwischen Drain-Source-Strom und Drain-Source-Spannung bei unterschiedlichen Gate-Source-Spannungen) genutzt. Auch Kennlinien im Bereich des Überganges zwischen Sperrbereich und linearem Bereich des Feldeffekttransistors, also bei sehr kleinen Gate-Source-Spannungen $U_{gs}$, können genutzt werden. Dadurch ergibt sich ein besonders hoher Messbereich für die Bestimmung des gesuchten Stroms.

Der vorgebbare Bereich für den Spannungsabfall $U_{ds}$ zwischen Drain und Source kann beispielsweise zwischen 10 mV und 90 mV liegen. Hier können jedoch, unter anderem abhängig vom verwendeten Bauteil und der gewünschten Anwendung, auch andere Bereiche besser geeignet sein.

Vorteilhafte Ausgestaltungen und Weiterbildungen der Erfindung ergeben sich aus den Unteransprüchen, sowie aus der Beschreibung in Zusammenschau mit den Figuren der Zeichnung.

Vorteilhaft ist es, wenn der Zusammenhang zwischen Drain-Source-Strom, Drain-Source-Spannung und Gate-Source-Spannung in einem Initialisierungsschritt ermittelt wird. Anstatt auf die Angaben des Herstellers in Datenblättern zu vertrauen, wird bei dieser Variante der Erfindung der Zusammenhang zwischen Drain-Source-Strom, Drain-Source-Spannung und Gate-Source-Spannung eines konkreten Transistors ermittelt.

Messstreuungen aufgrund von Fertigungstoleranzen des Transistors können so vermieden werden. Wenn die Ermittlung des genannten Zusammenhangs zu einem späteren Zeitpunkt wiederholt wird, können weiterhin Messungenauigkeiten aufgrund der Alterung der Bauteile verhindert werden.

Vorteilhaft ist es weiterhin, wenn der Zusammenhang zwischen Drain-Source-Strom, Drain-Source-Spannung und Gate-Source-Spannung als Kanalwiderstand in Form eines Polynoms

$$R_{ds}= k_0 + k_1 . U_{ds} + k_2 . U_{ds}^2 + \dots + k_n . U_{ds}^n$$

vorliegt, wobei für unterschiedliche Steuerspannungen verschiedene Sätze von Koeffizienten $k_0..k_n$ vorgesehen sind. Ein Polynom eignet sich wegen der Nicht-Linearität des Kanalwiderstands besonders gut zu dessen Annäherung. Um den Einfluss der Steuerspannung zu berücksichtigen, werden verschiedene Koeffizienten-Sätze für die verschiedenen Steuerspannungen angelegt. Im Bereich zwischen den einzelnen Polynomen kann entweder lineare oder nichtlineare Interpolation erfolgen. Der gesuchte Strom kann dann leicht anhand der Formel

$$I_M = \frac{U_{ds}}{R_{ds}}$$

ermittelt werden

Besonders vorteilhaft ist ein Verfahren, bei dem

- zusätzlich die Temperatur des Transistors bestimmt wird,
- der bekannte Zusammenhang zwischen Drain-Source-Strom, Drain-Source-Spannung und Gate-Source-Spannung auch die Abhängigkeit von der Transistortemperatur umfasst und
- die Transistortemperatur bei der Bestimmung des gesuchten Stroms berücksichtigt wird.

Da die am Feldeffekttransistor abfallende Verlustleistung diesen unter Umständen erheblich erwärmt, ist es vorteilhaft, die Temperatur desselben bei der Bestimmung des Messstroms zu berücksichtigen, da die Temperatur doch merklichen Einfluss auf den Kanalwiderstand des Transistors hat. Insbesondere im Bereich kleiner Gate-Source-Spannungen weisen die Kennlinien für den Zusammenhang zwischen Drain-Source-Strom und Drain-Source-Spannung eine starke Abhängigkeit von der Temperatur auf, so dass die Berücksichtigung der Transistortemperatur in diesem Bereich besonders wichtig ist. Selbstverständlich kann auch eine sehr hohe oder sehr niedere Umgebungstemperatur, welche auf den Feldeffekttransistor einwirkt, das Messergebnis ohne Berücksichtigung derselben erheblich verfälschen.

Vorteilhaft ist es in diesem Zusammenhang, wenn für unterschiedliche Transistortemperaturen verschiedene Koeffizienten-Sätze vorgesehen sind. Wenn der Zusammenhang zwischen Drain-Source-Strom, Drain-Source-Spannung und Gate-Source-Spannung als Kanalwiderstand in Form eines Polynoms gespeichert wird, können für unterschiedliche Transistortemperaturen einfach verschiedene Koeffizienten-Sätze vorgesehen werden, um den Einfluss der Temperatur zu berücksichtigen. Die Berücksichtigung der Transistortemperatur ist somit besonders einfach.

Günstig ist es, wenn der Spannungsabfall zwischen Drain und Source des Transistors im Wesentlichen konstant und unabhängig vom zu messenden Strom ist. Auf diese Weise kann der "Messbereich" des Transistors beziehungsweise die am Transistor abfallende Verlustleistung besonders genau eingestellt werden

In einer weiteren vorteilhaften Variante der Erfindung ist als Temperatursensor zumindest eine Temperaturmessdiode vorgesehen. Temperaturmessdioden sind erprobte und zuverlässige Bauelemente für die Temperaturmessung. Die erfindungsgemäße Vorrichtung kann somit mit geringem technischen Aufwand in die Praxis umgesetzt werden und ist darüber hinaus auch noch wenig fehleranfällig. Selbstverständlich können auch andere Bauelemente für die Temperaturmessung eingesetzt werden, beispielsweise Thermistoren.

Besonders vorteilhaft ist es in diesem Zusammenhang, wenn die zumindest eine Temperaturmessdiode mit einer Konstantstromquelle oder mit einer Konstantspannungsquelle mit Vorwiderstand verbunden ist und die an der zumindest einen Temperaturmessdiode abfallende Spannung als Maß für die Transistortemperatur herangezogen wird. Da sich die Spannung an den Temperaturmessdioden proportional mit der Temperatur ändert, ist eine Temperaturmessung in diesem Fall besonders einfach möglich.

Besonders vorteilhaft ist es weiterhin, wenn die Mittel zum Bestimmen der Transistortemperatur einen Temperatursensor umfassen, welcher auf demselben Substrat wie der Transistor angeordnet ist. Auf diese Weise kann ein Messfehler der Transistortemperatur weitgehend vermieden werden, da der Temperatursensor (z.B. die Temperaturmessdioden) im Wesentlichen dieselbe Temperatur hat wie der Transistor.

In einer weiteren vorteilhaften Variante der Erfindung sind mehrere Transistoren parallel geschaltet. Durch eine Parallelschaltung mehrerer Transistoren ist eine einfache Erweiterung des Strommessbereichs möglich, sollte der ohnehin schon große Messbereich der erfindungsgemäßen Vorrichtung nicht ausreichend sein. Die parallelgeschalteten Transistoren können dabei gleiche oder aber auch unterschiedliche Eigenschaften aufweisen. Weiterhin kann die Temperaturmessung individuell auf jedem Transistor erfolgen. Denkbar ist auch eine Temperaturmessung nur an einem Transistor, wenn die Transistoren zum Beispiel auf einem gemeinsamen Kühlkörper montiert sind und ein geringer Genauigkeitsverlust akzeptiert wird. Auch können die Temperaturmessdioden der einzelnen FETs (gleicher Bauart) in Serie geschaltet und dadurch eine mittlere Temperatur bestimmt werden.

Vorteilhaft ist es aber auch, wenn mehrere Transistoren antiparallel geschaltet sind. Mit einer antiparallelen Schaltung von Transistoren können sowohl positive als auch negative Ströme gemessen werden. Die erfindungsgemäße Vorrichtung kann somit bidirektional betrieben werden.

An dieser Stelle wird darauf hingewiesen dass sich die zum erfindungsgemäßen Verfahren genannten Varianten und daraus resultierenden Vorteile gleichermaßen auf die erfindungsgemäße Vorrichtung beziehen und umgekehrt.

Weiterhin wird festgehalten, dass die erfindungsgemäße Vorrichtung sowohl in Software, in Hardware oder in einer Kombination derselben abgebildet werden kann. Wenn die Steuerung in Software ausgestaltet ist, dann werden die nötigen Verfahrensschritte und Parameter beispielsweise in einem Speicher gespeichert und zur Laufzeit in einen Prozessor geladen und dort abgearbeitet.

Die obigen Ausgestaltungen und Weiterbildungen der Erfindung lassen sich auf beliebige Art und Weise kombinieren.

KURZE BESCHREIBUNG DER FIGUREN

Die vorliegende Erfindung wird nachfolgend anhand der in den schematischen Figuren der Zeichnung angegebenen Ausführungsbeispiele näher erläutert. Es zeigen dabei:

Figur 1    Ausgangskennlinien eines Feldeffekttransistors;

Figur 2    die Abhängigkeit des Kanalwiderstands eines Feldeffekttransistors von der Temperatur;

Figur 3    eine Anordnung, bei der ein Feldeffekttransistor und Temperaturmessdioden auf einem gemeinsamen Substrat angeordnet sind;

Figur 4    die Abhängigkeit der an den Temperaturmessdioden abfallenden Spannung von der Temperatur;

Figur 5    eine erfindungsgemäße Vorrichtung zur Messung eines elektrischen Stroms und

Figur 6    ein Beispiel wie der Zusammenhang zwischen Messstrom und Drain-Source-Spannung ermittelt werden kann.

DETAILIERTE BESCHREIBUNG DER ERFINDUNG

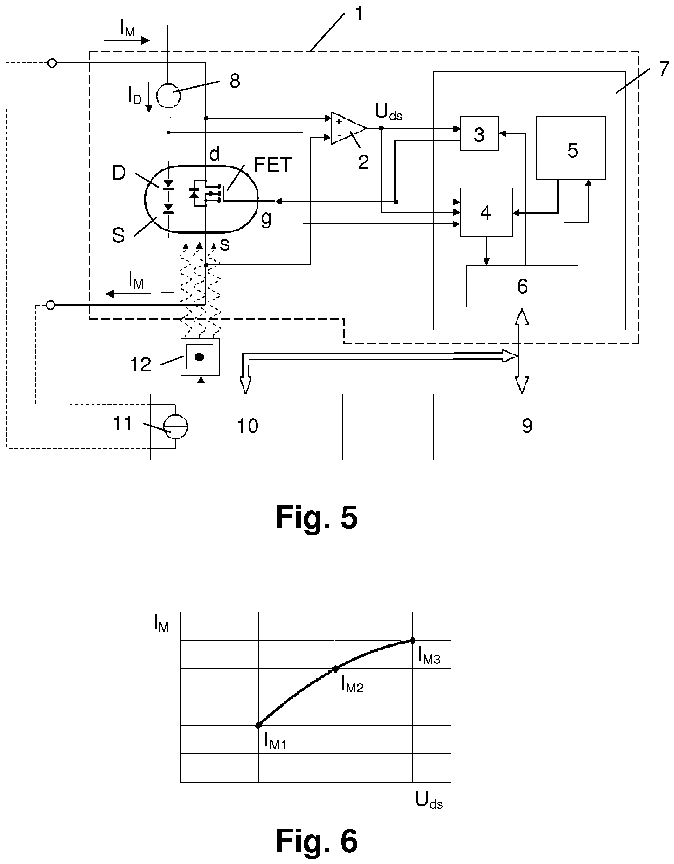

Fig. 5 zeigt eine Variante einer erfindungsgemäßen Vorrichtung 1 zum Messen eines Stroms $I_M$. Die Vorrichtung 1 umfasst einen Transistor FET, der über Drain d und Source s in einen Strompfad geschaltet ist. Über einen Differenzverstärker 2 wird die Drain-Source-Spannung $U_{ds}$ gemessen und an eine Regeleinrichtung 3 geleitet. Desweiteren wird die Drain-Source-Spannung $U_{ds}$ an einen Eingang einer Messwerterfassungseinheit 4 geleitet. Ein Ausgang der Regeleinrichtung 3 ist mit dem Gate g des Transistors FET sowie mit einem Eingang der Messwerterfassungseinheit 4 verbunden. Schließlich ist die Messwerterfassungseinheit 4 mit einem Speicher 5 verbunden, in dem der Zusammenhang zwischen Drain-Source-Strom $I_{ds}$, Drain-Source-Spannung $U_{ds}$ und Gate-Source-Spannung $U_{gs}$ gespeichert ist, beispielsweise in Form einer Funktion für den Drain-Source-Strom $I_{ds}$ in Abhängigkeit der Drain-Source-Spannung $U_{ds}$ und der Gate-Source-Spannung $U_{gs}$.

Zusätzlich umfasst die Vorrichtung 1 eine Datenschnittstelle 6 zur Kommunikation der Regeleinrichtung 3, der Messwerterfassungseinheit 4 und des Speichers 5 mit externen Geräten.

Die Regeleinrichtung 3, die Messwerterfassungseinheit 4, der Speicher 5 und die Datenschnittstelle 6 sind im gezeigten Beispiel in einem Messmodul 7 untergebracht. Dies ist zwar eine vorteilhafte aber rein willkürliche Gruppierung. Selbstverständlich können die für die Erfindung nötigen Einrichtungen auch anders gruppiert werden. Beispielsweise könnte der Differenzverstärker 2 ebenfalls Teil des Messmoduls 7 sein. Desweiteren wird festgehalten dass die Aufteilung der erfindungsgemäßen Funktion in Differenzverstärker, Regeleinrichtung 3, Messwerterfassungseinheit 4 und Speicher 5 ebenfalls rein willkürlich ist. Die Funktionen können gleichermaßen von anderen funktionalen Einheiten erfüllt werden. Schließlich wird erwähnt, dass die zur Umsetzung der Erfindung notwendigen Funktionen in Hardware und/oder Software gebildet sein können. Denkbar ist beispielsweise, dass die Funktionalität hauptsächlich durch ein in einem Prozessor ablaufendes Programm gebildet ist. Denkbar ist aber auch, dass die Funktion von einem ASIC (Application Specific Integrated Circuit) gebildet ist.

Die Grundfunktion der erfindungsgemäßen Vorrichtung ist nun wie folgt:

Mit Hilfe der Regeleinrichtung 3 wird eine Steuerspannung $U_{gs}$ zwischen Gate g und Source s des Transistors FET angelegt, derart, dass der Spannungsabfall $U_{ds}$ zwischen Drain d und Source s am Transistor FET im Strompfad innerhalb eines vorgebbaren Bereichs bleibt. In einer Variante der Erfindung wird die Steuerspannung $U_{gs}$ so gewählt, dass der Spannungsabfall $U_{ds}$ überhaupt im Wesentlichen konstant und unabhängig vom zu messenden Strom ist. Mit Hilfe der Messwerterfassungseinheit 4 werden nun die konkreten Werte für die Steuerspannung $U_{gs}$ sowie für den besagten Spannungsabfall $U_{ds}$ bestimmt. Sodann wird der gesuchte Strom $I_M$ mit Hilfe des im Speicher 5 gespeicherten Zusammenhangs zwischen Drain-Source-Strom $I_{ds}$, Drain-Source-Spannung $U_{ds}$ und Gate-Source-Spannung $U_{gs}$ ermittelt. Bei bekannter Transistorkennlinie, bekannter Drain-Source-Spannung $U_{ds}$ und bekannter Gate-Source-Spannung $U_{gs}$ kann der Drain-Source-Strom $I_{ds}$ bestimmt werden, welcher zugleich dem gesuchten Messstrom $I_M$ entspricht.

Beispielsweise ist der genannte Zusammenhang zwischen Drain-Source-Strom $I_{ds}$, Drain-Source-Spannung $U_{ds}$ und Gate-Source-Spannung $U_{gs}$ aus Datenblättern bekannt oder wird besser noch in einem Initialisierungsschritt ermittelt. In letzterem Fall können Messfehler, welche durch Fertigungsstreuungen des Transistors FET bedingt sind, weitgehend vermieden werden.

In einer bevorzugten Variante der Erfindung wird der Zusammenhang zwischen Drain-Source-Strom $I_{ds}$, Drain-Source-Spannung $U_{ds}$ und Gate-Source-Spannung $U_{gs}$ als Kanalwiderstand $R_{ds}$ in Form eines Polynoms

$$R_{ds} = k_0 + k_1 . U_{ds} + k_2 . U_{ds}^2 + \dots + k_n . U_{ds}^n$$

gespeichert, wobei für unterschiedliche Steuerspannungen $U_{gs}$ verschiedene Sätze von Koeffizienten $k_0 .. k_n$ vorgesehen sind.

Da die Kennlinien des Transistors FET auch stark mit dessen Temperatur variieren wird in einer weiteren bevorzugten Variante der Erfindung zusätzlich die Temperatur T des Transistors FET bestimmt und bei der Bestimmung des gesuchten Stroms $I_M$ berücksichtigt. Dazu wird der bekannte Zusammenhang zwischen Drain-Source-Strom $I_{ds}$, Drain-Source-Spannung $U_{ds}$ und Gate-Source-Spannung $U_{gs}$ dahingehend erweitert, dass auch die Abhängigkeit von der Transistortemperatur T mitumfasst ist. Wird der genannte Zusammenhang in Form des zuvor erwähnten Polynoms gespeichert, dann können für unterschiedliche Transistortemperaturen T (und für verschiedene Gate-Source-Spannungen $U_{gs}$) verschiedene Koeffizienten-Sätze $k_0 .. k_n$ vorgesehen werden.

Für die Bestimmung der Transistortemperatur T umfasst die Vorrichtung zusätzlich zwei Temperaturmessdioden D, welche auf demselben Substrat S angeordnet sind wie der Transistor FET, um so ein möglichst unverfälschtes Messergebnis zu erhalten. Die Temperaturmessdioden D sind mit einer Konstantstromquelle 8 verbunden, sodass an den Temperaturmessdioden D eine von der Temperatur der Dioden D und damit der Transistortemperatur T abhängige Spannung $U_T$ abfällt (siehe hierzu auch die Figuren 3 und 4). Diese Spannung $U_T$ wird von der Messwerterfassungseinheit 4 gemessen und bei der Ermittlung des Drain-Source-Stroms $I_{ds}$ berücksichtigt, beispielsweise dadurch, dass wie zuvor erwähnt verschiedene Koeffizienten-Sätze $k_0 .. k_n$ für das Polynom des Kanalwiderstands $R_{ds}$ vorgesehen werden. Selbstverständlich sind auch andere temperaturabhängige Elemente für die Messung der Transistortemperatur T geeignet (z.B. Thermistor), insbesondere solche, die auf demselben Substrat S wie der Transistor FET angeordnet werden können. Anstelle der Konstantstromquelle 8 kann auch eine Konstantspannungsquelle mit Vorwiderstand vorgesehen sein. An dieser Stelle wird auch angemerkt, dass die Anzahl der verwendeten Temperaturmessdioden D bloß beispielhaft zu sehen ist. Andere Varianten der erfinderischen Schaltung weisen beispielsweise nur eine Temperaturmessdiode D auf.

Vorteilhaft ist die Steuerung der Gate-Spannung $U_{gs}$ durch die Regeleinrichtung 3 von der Messung derselben durch die Messwerterfassungseinheit 4 getrennt. Auf diese Weise kann einerseits ein Regelkreis aufgebaut werden, andererseits wird die tatsächlich vorhanden Gate-Spannung $U_{gs}$ bestimmt. Möglich ist aber auch, die Gate-Spannung

$U_{gs}$ bloß zu steuern und direkt deren Sollwert für die Bestimmung des gesuchten Stroms $I_M$ heranzuziehen. Diese Schaltungsvariante liefert zwar nicht so genaue Ergebnisse, ist aber einfacher aufgebaut.

Die Fig. 5 zeigt schließlich auch externe, an die erfindungsgemäße Vorrichtung 1 angeschlossene Geräte, nämlich einen Personal Computer (PC) 9 zur Datenvisualisierung und Weiterverarbeitung der Messwerte, eine Kalibriereinheit 10 mit integrierter Konstantstromquelle 11 und eine an die Kalibriereinheit 10 angeschlossene Heizung 12. Alternativ oder zusätzlich kann auch eine Kühlung vorgesehen sein, beispielsweise bei kleinen Betriebstemperaturen, bzw. hohen Kalibrierströmen.

Im Zuge des Kalibriervorgangs wird eine Koeffizientenmatrix $k_0 .. k_n$ für den Kanalwiderstand $R_{ds}$ bestimmt und im nichtflüchtigen Speicher 5 des Messmoduls 7 abgelegt. Dabei steuert die Kalibriereinheit 10 die Heizung 12 so an, dass die - vorzugsweise in einer Klimakammer untergebrachte Vorrichtung 1 - auf eine bestimmte Temperatur gebracht werden kann. Wird nun das Messmodul 7 kalibriert, so wird es (temporär) an die Kalibriereinheit 10 angeschlossen und über ein spezielles Kommando über die Schnittstelle 6 in den Kalibriermodus versetzt. Im Kalibriermodus wird ein definierter Betriebstemperaturbereich (z.B. 0°C bis 80°C) in mehreren Stufen (z.B. 32 Stufen) durchlaufen. Die einzelnen Inkremente können konstant (z.B. 2.5°C) aber auch variabel sein. Nachdem eine bestimmte Temperatur T, die über die Temperaturmessdioden D gemessen wird, eingestellt wurde, wird ein Startwert für die Steuer- oder Gate-Spannung $U_{gs}$ eingestellt. Ist die Temperatur T und die Gate-Spannung $U_{gs}$ konstant, so wird über die Konstantstromquelle 11 ein Kalibrierstrom derart geregelt, dass ein vorgegebener Spannungsabfall $U_{ds}$ (z.B. 40mV) am Transistor FET auftritt.

Wie bereits erwähnt und in Fig. 1 ersichtlich, ist der Kanalwiderstand $R_{ds}$ nur in einem kleinen Bereich annähernd linear. Für präzise Messungen ist es daher erforderlich, den Kanalwiderstand mit einem Polynom höherer Ordnung zu beschreiben.

Daher werden wie in Fig. 6 dargestellt, mehrere Werte für $U_{ds}$ (z.B. 20, 40 und 60mV) vorgegeben und die dazugehörigen Prüfströme ($I_{M1}$, $I_{M2}$, $I_{M3}$, etc.) ermittelt. In weiterer Folge werden die Polynomkoeffizienten $k_0 .. k_n$, welche den dynamischen Kanalwiderstand $R_{ds}$ bei einer bestimmten Gate-Spannung $U_{gs}$ und Substrat- beziehungsweise Transistortemperatur T beschreiben, berechnet und über die Datenschnittstelle 6 in die $R_{ds}$-Koeffizientenmatrix des Messmoduls 7 gespeichert.

$$R_{ds} = k_0 + k_1 . U_{ds} + k_2 . U_{ds}^2 + \dots + k_n . U_{ds}^n$$

Dieser Vorgang wird für verschiedene Gate-Spannungen $U_{gs}$ (z.B. 50 Inkremente) durchgeführt. Wie bei den Temperaturstufen können auch hier die einzelnen Inkremente konstant oder variabel sein. Nachdem die Koeffizienten $k_0 .. k_n$ aller Gate-Spannungswerte $U_{gs}$ für einen Durchlauf ermittelt wurden, wird die nächst höhere Temperatur mit Hilfe der Heizung 12 eingestellt und der Kalibriervorgang fortgesetzt.

Nach Durchlauf aller Temperaturstufen und Gate-Spannungswerte $U_{gs}$ ist der Kalibriervorgang beendet und das Messmodul 7 ist einsatzbereit. Eine erneute Kalibrierung ist aber selbstverständlich jederzeit möglich, beispielsweise um Messungenauigkeiten aufgrund von Alterungserscheinungen zu vermeiden.

Zwar können prinzipiell beliebig viele Koeffizienten-Sätze $k_0 .. k_n$ beziehungsweise Kennlinien-Scharen ermittelt werden, jedoch liegt es in der Natur der Sache, dass bei der Ermittlung eines Drain-Source-Stroms $I_M$ häufig auch Zwischenwerte für die Spannung $U_T$ und die Gate-Spannung $U_{gs}$ zu verarbeiten sind. In diesem Fall können die Polynomkoeffizienenten $k_0 .. k_n$ für $R_{ds}$ aus benachbarten Polynomen ermittelt werden. Das kann entweder durch lineare oder nichtlineare Interpolation erfolgen.

Durch eine Parallelschaltung mehrerer Transistoren FET mit unterschiedlichen Eigenschaften ist weiterhin eine Erweiterung des Strommessbereichs möglich. Mit einer antiparallelen Schaltung von Transistoren FET können darüber hinaus sowohl positive als auch negative Ströme gemessen werden. Die parallel geschalteten Transistoren FET können dabei sowohl gleiche als auch unterschiedliche Eigenschaften aufweisen. Bei der Verwendung gleichartiger Transistoren FET ist vorteilhaft mitunter eine gemeinsame Steuereinheit ausreichend.

Die Messmethode wurde mit einem selbstsperrenden n-Kanal MOSFET beschrieben. Es ist aber auch eine Verwendung anderer Feldeffekttransitoren möglich, beispielsweise selbstleitende FETs, p-Kanal MOSFET, etc.

Abschließend wird festgehalten dass die Darstellungen in den Figuren schematisch sind und daher auch zusätzliche Bestandteile oder auch weniger Bestandteile aufweisen können.

**Patentansprüche**

**1.** Verfahren zum Messen eines elektrischen Stroms ($I_M$) mit Hilfe eines in einen Strompfad eingefügten Feldeffekttransistors (FET), umfassend die Schritte:

- Anlegen einer Steuerspannung ($U_{gs}$) zwischen Gate (g) und Source (s) des Transistors (FET) derart, dass der Spannungsabfall ($U_{ds}$) zwischen Drain (d) und Source (s) am Transistor (FET) im Strompfad innerhalb eines vorgebbaren Bereichs bleibt,
- Bestimmen des besagten Spannungsabfalls ($U_{ds}$),
- Bestimmen der Steuerspannung ($U_{gs}$),
- Bestimmen des gesuchten Stroms ($I_M$) anhand des besagten Spannungsabfalls ($U_{ds}$), der Steuerspannung ($U_{gs}$) und eines bekannten Zusammenhangs zwischen Drain-Source-Strom ($I_{ds}$), Drain-Source-Spannung ($U_{ds}$) und Gate-Source-Spannung ($U_{gs}$), **dadurch gekennzeichnet, dass** die Steuerspannung ($U_{gs}$) zwischen Gate (g) und Source (s) des Transistors (FET) konstant gehalten wird solange der Spannungsabfall ($U_{ds}$) zwischen Drain (d) und Source (s) im vorgebbaren Bereich liegt und die Steuerspannung ($U_{gs}$) um einen diskreten Wert erhöht bzw. verringert wird, wenn der Spannungsabfall ($U_{ds}$) zwischen Drain (d) und Source (s) den vorgebbaren Bereich verlässt.

2. Verfahren nach Anspruch 1, **dadurch gekennzeichnet, dass** der vorgebbare Bereich für den Spannungsabfall ($U_{ds}$) zwischen Drain (d) und Source (s) am Transistor (FET) zwischen 10 mV und 90 mV liegt.

3. Verfahren nach einem der Ansprüche 1 bis 2, **dadurch gekennzeichnet, dass** der Zusammenhang zwischen Drain-Source-Strom ($I_{ds}$), Drain-Source-Spannung ($U_{ds}$) und Gate-Source-Spannung ($U_{gs}$) in einem Initialisierungsschritt ermittelt wird.

4. Verfahren nach einem der Ansprüche 1 bis 3, **dadurch gekennzeichnet, dass** der Zusammenhang zwischen Drain-Source-Strom ($I_{ds}$), Drain-Source-Spannung ($U_{ds}$) und Gate-Source-Spannung ($U_{gs}$) als Kanalwiderstand ($R_{ds}$) in Form eines Polynoms

$$R_{ds} = k_0 + k_1 . U_{ds} + k_2 . U_{ds}^2 + \ldots + k_n . U_{ds}^n$$

vorliegt, wobei für unterschiedliche Steuerspannungen ($U_{gs}$) verschiedene Sätze von Koeffizienten $k_0 .. k_n$ vorgesehen sind.

5. Verfahren nach einem der Ansprüche 1 bis 4, **dadurch gekennzeichnet, dass**

- zusätzlich die Temperatur (T) des Transistors (FET) bestimmt wird,
- der bekannte Zusammenhang zwischen Drain-Source-Strom ($I_{ds}$), Drain-Source-Spannung ($U_{ds}$) und Gate-Source-Spannung ($U_{gs}$) auch die Abhängigkeit von der Transistortemperatur (T) umfasst und
- die Transistortemperatur (T) bei der Bestimmung des gesuchten Stroms ($I_M$) berücksichtigt wird.

6. Verfahren nach den Ansprüchen 4 und 5, **dadurch gekennzeichnet, dass** für unterschiedliche Transistortemperaturen (T) verschiedene Koeffizienten-Sätze $k_0 .. k_n$ vorgesehen sind

7. Vorrichtung (1) zum Messen eines elektrischen Stroms ($I_M$), umfassend einen Transistor (FET) zum Einfügen in einen Strompfad, die Vorrichtung weiter umfassend

- eine Regeleinrichtung (3), welche zum Anlegen einer Steuerspannung ($U_{gs}$) zwischen Gate (g) und Source (s) des Transistors (FET) vorgesehen ist, derart, dass der Spannungsabfall ($U_{ds}$) zwischen Drain (d) und Source (s) am Transistor (FET) im Strompfad innerhalb eines vorgebbaren Bereichs bleibt, wobei die Steuerspannung ($U_{gs}$) zwischen Gate (g) und Source (s) des Transistors (FET) konstant gehalten wird solange der Spannungsabfall ($U_{ds}$) zwischen Drain (d) und Source (s) im vorgebbaren Bereich liegt und die Steuerspannung ($U_{gs}$) um einen diskreten Wert erhöht bzw. verringert wird, wenn der Spannungsabfall ($U_{ds}$) zwischen Drain (d) und Source (s) den vorgebbaren Bereich verlässt,
- Mittel (4) zum Bestimmen des besagten Spannungsabfalls ($U_{ds}$) und der Steuerspannung ($U_{gs}$),
- Mittel (5) zum Bestimmen des gesuchten Stroms ($I_M$) anhand des besagten Spannungsabfalls ($U_{ds}$), der Steuerspannung ($U_{gs}$) und eines bekannten Zusammenhangs zwischen Drain-Source-Strom ($I_{ds}$), Drain-Source-Spannung ($U_{ds}$) und Gate-Source-Spannung ($U_{gs}$) .

8. Vorrichtung (1) nach Anspruch 7, **dadurch gekennzeichnet, dass**

- diese Mittel (D) zur Bestimmung der Temperatur des Transistors (FET) umfasst,
- der in einem Initialisierungsschritt ermittelte Zusammenhang des Transistorstroms ($I_{ds}$) auch die Abhängigkeit des Transistorstroms ($I_{ds}$) von der Transistortemperatur (T) umfasst und
- die Mittel zum Bestimmen des gesuchten Stroms ($I_M$) zur Berücksichtigung der Transistortemperatur (T) vorgesehen sind.

9. Vorrichtung (1) nach einem der Ansprüche 7 bis 8, **dadurch gekennzeichnet, dass** mehrere Transistoren (FET) parallel geschaltet sind.

10. Vorrichtung (1) nach einem der Ansprüche 7 bis 8, **dadurch gekennzeichnet, dass** mehrere Transistoren (FET) antiparallel geschaltet sind.

**Claims**

1. A method for measuring an electrical current ($I_M$) with the aid of a field effect transistor (FET) inserted into a current path, comprising the steps of:

   - applying a control voltage ($U_{gs}$) between the gate (g) and source (s) of the transistor (FET) in such a way that the voltage drop ($U_{ds}$) between the drain (d) and source (s) at the transistor (FET) in the current path remains within a specifiable range,
   - determining said voltage drop ($U_{ds}$),
   - determining the control voltage ($U_{gs}$),
   - determining the value of the current of interest ($I_M$) on the basis of said voltage drop ($U_{ds}$), the control voltage ($U_{gs}$), and a known relationship between the drain-source current ($I_{ds}$), the drain-source voltage ($U_{ds}$) and the gate-source voltage ($U_{gs}$), **characterized in that** the control voltage ($U_{gs}$) between the gate (g) and the source (s) of the transistor (FET) is held constant for as long as the voltage drop ($U_{ds}$) between the drain (d) and the source (s) remains within the specifiable range, and the control voltage ($U_{gs}$) is increased or decreased by a discrete amount if the voltage drop ($U_{ds}$) between the drain (d) and the source (s) leaves the specifiable range.

2. A method as claimed in claim 1, **characterized in that** the specifiable range for the voltage drop ($U_{ds}$) between the drain (d) and the source (s) at the transistor (FET) lies between 10 mV and 90 mV.

3. A method as claimed in one of claims 1 to 2, **characterized in that** the relationship between the drain-source current ($I_{ds}$), the drain-source voltage ($U_{ds}$) and the gate-source voltage ($U_{gs}$) is determined in an initialization step.

4. A method as claimed in one of claims 1 to 3, **characterized in that** the relationship between the drain-source current ($I_{ds}$), the drain-source voltage ($U_{ds}$) and the gate-source voltage ($U_{gs}$) is present as a channel resistance ($R_{ds}$) in the form of a polynomial

$$R_{ds} = k_0 + k_1 \cdot U_{ds} + k_2 \cdot U_{ds}^2 + \ldots + k_n \cdot U_{ds}^n$$

whereby various sets of coefficients $k_0..k_n$ are provided for different control voltages ($U_{gs}$).

5. A method as claimed in one of claims 1 to 4, **characterized in that**

   - the temperature (T) of the transistor (FET) is also determined,
   - the known relationship between the drain-source current ($I_{ds}$), the drain-source voltage ($U_{ds}$) and the gate-source voltage ($U_{gs}$) also comprises the dependency on the transistor temperature (T), and
   - the transistor temperature (T) is taken into account when determining the value of the current of interest ($I_M$).

6. A method as claimed in claims 4 and 5, **characterized in that** different sets of coefficients $k_0..k_n$ are provided for different transistor temperatures (T).

7. Apparatus (1) for measuring an electrical current ($I_M$), comprising a transistor (FET) for insertion into a current path, the apparatus comprising

- a control unit (3), which is provided for applying a control voltage ($U_{gs}$) between the gate (g) and the source (s) of the transistor (FET) in such a way that the voltage drop ($U_{ds}$) between the drain (d) and the source (s) at the transistor (FET) in the current path remains within a specifiable range,
wherein the control voltage ($U_{gs}$) between the gate (g) and the source (s) of the transistor (FET) is held constant for as long as the voltage drop ($U_{ds}$) between the drain (d) and the source (s) remains within the specifiable range, and the control voltage ($U_{gs}$) is increased or decreased by a discrete amount if the voltage drop ($U_{ds}$) between the drain (d) and the source (s) leaves the specifiable range,
- means (4) for determining said voltage drop ($U_{ds}$) and the control voltage ($U_{gs}$),
- means (5) for determining the value of the current of interest ($I_M$) on the basis of said voltage drop ($U_{ds}$), the control voltage ($U_{gs}$) and of a known relationship between the drain-source current ($I_{ds}$), the drain-source voltage ($U_{ds}$) and the gate-source voltage ($U_{gs}$) .

8. Apparatus (1) as claimed in claim 7, **characterized in that**

- it comprises means (D) for determining the temperature of the transistor (FET),
- the relationship governing the transistor current ($I_{ds}$) that is determined in an initialization step also comprises the dependency of the transistor current ($I_{ds}$) on the transistor temperature (T), and
- the means for determining the value of the current of interest ($I_M$) is implemented to take the transistor temperature (T) into account.

9. Apparatus (1) as claimed in one of claims 7 to 8, **characterized in that** a plurality of transistors (FET) are connected in parallel.

10. Apparatus (1) as claimed in one of claims 7 to 8, **characterized in that** a plurality of transistors (FET) are connected in antiparallel.

**Revendications**

1. Procédé de mesure d'un courant électrique ($I_M$) à l'aide d'un transistor à effet de champ (FET) inséré dans un trajet de courant, comprenant les étapes consistant à :

- appliquer une tension de commande ($U_{gs}$) entre la grille (g) et la source (s) du transistor (FET), de telle sorte que la chute de tension ($U_{ds}$) entre le drain (d) et la source (s) sur le transistor (FET) reste dans une plage prédéfinissable, dans le trajet de courant,
- déterminer la dite chute de tension ($U_{ds}$),
- déterminer la tension de commande ($U_{gs}$),
- déterminer le courant recherché ($I_M$) à l'aide de ladite chute de tension ($U_{ds}$), de la tension de commande ($U_{gs}$) et d'une relation connue entre le courant drain-source ($I_{ds}$), la tension drain-source ($U_{ds}$) et la tension grille-source ($U_{gs}$),

**caractérisé en ce que** la tension de commande ($U_{gs}$) entre la grille (g) et la source (s) du transistor (FET) est maintenue à un niveau constant, aussi longtemps que la chute de tension ($U_{ds}$) entre le drain (d) et la source (s) se situe dans la plage prédéfinissable et la tension de commande ($U_{gs}$) est augmentée ou diminuée d'une valeur discrète lorsque la chute de tension ($U_{ds}$) entre le drain (d) et la source (s) quitte la plage prédéfinissable.

2. Procédé selon la revendication 1, **caractérisé en ce que** la plage prédéfinissable pour la chute de tension ($U_{ds}$) entre le drain (d) et la source (s) sur le transistor (FET) se situe entre 10 mV et 90 mV.

3. Procédé selon l'une quelconque des revendications 1 et 2, **caractérisé en ce que** la relation entre le courant drain-source ($I_{ds}$), la tension drain-source ($U_{ds}$) et la tension grille-source ($U_{gs}$) est déterminée lors d'une étape d'initialisation.

4. Procédé selon l'une quelconque des revendications 1 à 3, **caractérisé en ce que** la relation entre le courant drain-source ($I_{ds}$), la tension drain-source ($U_{ds}$) et la tension grille-source ($U_{gs}$) se présente en tant que résistance de canal ($R_{ds}$), sous la forme d'un polynôme

$$R_{ds} = k_0 + k_1 \cdot U_{ds} + k_2 \cdot U_{ds}^2 + \dots + k_n \cdot U_{ds}^n$$

pour différentes tensions de commande ($U_{gs}$) étant prévus différents jeux de coefficients $k_0 .. k_n$.

5. Procédé selon l'une quelconque des revendications 1 à 4, **caractérisé en ce que**

- la température (T) du transistor (FET) est en outre déterminée,
- la relation connue entre le courant drain-source ($I_{ds}$), la tension drain-source ($U_{ds}$) et la tension grille-source ($U_{gs}$) comprend également la dépendance par rapport à la température du transistor (T) et
- on tient compte de la température du transistor (T) lors de la détermination du courant recherché ($I_M$).

6. Procédé selon les revendications 4 et 5, **caractérisé en ce que** pour différentes températures du transistor (T) sont prévus différents jeux de coefficients $k_0 .. k_n$.

7. Dispositif (1) de mesure d'un courant électrique ($I_M$), comprenant un transistor (FET), destiné à être inséré dans un trajet de courant, le dispositif comprenant par ailleurs

- un système de réglage (3), lequel est prévu pour appliquer une tension de commande ($U_{gs}$) entre la grille (g) et la source (s) du transistor (FET), de telle sorte que la chute de tension ($U_{ds}$) entre le drain (d) et la source (s) sur le transistor (FET) reste à l'intérieur d'une plage prédéfinissable, dans le trajet de courant, la tension de commande ($U_{gs}$) entre la grille (g) et la source (s) du transistor (FET) étant maintenue à un niveau constant aussi longtemps que la chute de tension ($U_{ds}$) entre le drain (d) et la source (s) se situe dans la plage prédéfinissable et la tension de commande ($U_{gs}$) étant augmentée ou diminuée d'une valeur discrète lorsque la chute de tension ($U_{ds}$) ente le drain (d) et la source (s) quitte la plage prédéfinissable,
- des moyens (4), destinés à déterminer ladite chute de tension ($U_{ds}$) et la tension de commande ($U_{gs}$),
- des moyens (5), destinés à déterminer le courant recherché ($I_M$) à l'aide de ladite chute de tension ($U_{ds}$), de la tension de commande ($U_{gs}$) et d'une relation connue entre le courant drain-source ($I_{ds}$), la tension drain-source ($U_{ds}$) et la tension grille-source ($U_{gs}$) .

8. Dispositif (1) selon la revendication 7, **caractérisé**

- **en ce qu'**il comprend des moyens (D), destinés à déterminer la température du transistor (FET),
- **en ce que** la relation du courant du transistor ($I_{ds}$) déterminée au cours d'une étape d'initialisation comprend également la dépendance du courant du transistor ($I_{ds}$) par rapport à la température du transistor (T) et
- **en ce que** les moyens destinés à déterminer le courant recherché ($I_M$) sont prévus pour la prise en compte de la température du transistor (T).

9. Dispositif (1) selon l'une quelconque des revendications 7 et 8, **caractérisé en ce que** plusieurs transistors (FET) sont montés en parallèle.

10. Dispositif (1) selon l'une quelconque des revendications 7 et 8, **caractérisé en ce que** plusieurs transistors (FET) sont montés tête-bêche.

**Fig. 1**
(Stand der Technik)

**Fig. 2**
(Stand der Technik)

d

FET

D

g

S

s

$U_T$

## Fig. 3
(Stand der Technik)

$U_T$

T

## Fig. 4
(Stand der Technik)

**Fig. 5**

**Fig. 6**

**EP 2 548 035 B1**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- WO 1998010301 A1
- DE 102004039392 B3
- US 6867576 B2
- US 7154291 B2
- US 2009267589 A1
- EP 2068158 A2